# EUROPÄISCHE PATENTSCHRIFT

(11) **EP 0 823 131 B1**
(45) Veröffentlichungstag und Bekanntmachung des Hinweises auf die Patenterteilung: **25.08.1999**
(21) Anmeldenummer: 96908021.7
(22) Anmeldetag: 09.04.1996
(51) Int. Cl.: H01L 27/112, H01L 21/8246

(54) **FESTWERTSPEICHERZELLENANORDNUNG UND VERFAHREN ZU DEREN HERSTELLUNG**
READ-ONLY STORAGE CELL ARRANGEMENT AND PROCESS FOR ITS PRODUCTION
MEMOIRE MORTE ET SON PROCEDE DE PRODUCTION

(30) Priorität: 21.04.1995 DE 19514834
(43) Veröffentlichungstag der Anmeldung: 11.02.1998
(73) Patentinhaber: SIEMENS AKTIENGESELLSCHAFT, 80333 München (DE)
(72) Erfinder: HOFMANN, Franz, D-80995 München (DE); RISCH, Lothar, D-85579 Neubiberg (DE); KRAUTSCHNEIDER, Wolfgang, D-83104 Hohenthann (DE); RÖSNER, Wolfgang, D-81739 München (DE)
(86) Internationale Anmeldenummer: DE9600614
(87) Internationale Veröffentlichungsnummer: WO9633513

(56) Entgegenhaltungen:
- DE-A- 4 214 923
- GB-A- 2 017 406
- US-A- 4 663 644

## Beschreibung

Für viele elektronische Systeme werden Speicher benötigt, in die Daten in digitaler Form fest eingeschrieben sind. Derartige Speicher werden unter anderem als Festwertspeicher, Lesespeicher oder Read-Only-Memory bezeichnet.

Für große Datenmengen, wie insbesondere die digitale Abspeicherung von Musik, werden als Lesespeicher vielfach Kunststoffscheiben, sogenannte Compact Discs, verwendet, die mit Aluminium beschichtet sind. In der Beschichtung weisen diese Scheiben zweierlei punktartige Vertiefungen auf, die den logischen Werten Null und Eins zugeordnet werden. In der Anordnung dieser Vertiefungen ist die Information digital abgespeichert.

Zum Lesen der auf einer Compact Disc gespeicherten Daten wird die Scheibe in einem Lesegerät mechanisch rotiert. Die punktartigen Vertiefungen werden über eine Laserdiode und eine Photozelle abgetastet. Typische Abtastraten sind dabei 2 x 40 kHz. Auf einer Kunststoffscheibe können ca. 5 Gbit-Informationen gespeichert werden.

Das Lesegerät umfaßt bewegte Teile, die mechanisch verschleißen, die vergleichsweise viel Volumen benötigen, die nur einen langsamen Datenzugriff erlauben und großen Stromverbrauch aufweisen. Darüber hinaus ist das Lesegerät empfindlich gegen Erschütterungen und daher für mobile Systeme nur begrenzt geeignet.

Zur Speicherung kleinerer Datenmengen werden vielfach Festwertspeicher auf Halbleiterbasis, insbesondere Silizium, verwendet. Beim Auslesen der Speicherzellenanordnung werden die einzelnen Speicherzellen über eine Wortleitung ausgewählt. Die Gateelektrode der MOS-Transistoren ist jeweils mit einer Wortleitung verbunden. Der Eingang jedes MOS-Transistors ist mit einer Referenzleitung verbunden, der Ausgang mit einer Bitleitung. Beim Lesevorgang wird bewertet, ob ein Strom durch den Transistor fließt oder nicht. Entsprechend werden die logischen Werte Null und Eins zugeordnet.

Technisch wird die Speicherung von Null und Eins bei diesen Festwertspeichern dadurch bewirkt, daß in Speicherzellen, in denen der dem Zustand "kein Stromfluß durch den Transistor" zugeordnete logische Wert gespeichert ist, kein MOS-Transistor hergestellt wird oder keine leitende Verbindung zur Bitleitung realisiert wird. Alternativ können die beiden logischen Werte durch MOS-Transistoren realisiert werden, die durch unterschiedliche Implantationen im Kanalgebiet unterschiedliche Einsatzspannungen aufweisen.

Diese bekannten Siliziumspeicher weisen meist einen planaren Aufbau auf. Damit wird pro Speicherzelle ein minimaler Flächenbedarf erforderlich, der bei etwa 6 bis 8 F² liegt, wobei F die in der jeweiligen Technologie kleinste herstellbare Strukturgröße ist. Planare Festwertsiliziumspeicher sind damit bei einer 0,4 µm-Technologie auf Speicherdichten um 0,9 Bit/µm² begrenzt.

Aus US-A- 4 954 854 ist bekannt, in einem Festwertspeicher vertikale MOS-Transistoren zu verwenden. Dazu wird die Oberfläche des Siliziumsubstrats mit lochartigen Gräben versehen, an die am Boden ein Sourcegebiet angrenzt, an die an der Substratoberfläche ein den Graben umgebendes Draingebiet angrenzt und entlang deren Flanken ein Kanalgebiet angeordnet ist. Die Oberfläche des Grabens wird mit einem Gatedielektrikum versehen und der Graben mit einer Gateelektrode aufgefüllt. Null und Eins werden in dieser Anordnung dadurch unterschieden, daß für einen der logischen Werte kein Graben geätzt und kein Transistor hergestellt wird. Benachbarte Speicherzellen sind durch Isolationsstrukturen, die seitlich davon angeordnet sind, gegeneinander isoliert.

Aus GB-A-2 017 406 ist eine Festwertspeicherzellenanordnung bekannt, bei der die Programmierung dadurch erfolgt, daß an vorbestimmten Orten MOS-Gateelektroden realisiert werden.

DE-A-4 214 923 offenbart eine ROM-Zellenanordnung, die vertikale MOS-Transistoren enthaltende, streifenförmige Isolationsgräben aufweist.

Der Erfindung liegt das Problem zugrunde, eine Festwertspeicherzellenanordnung auf Halbleiterbasis anzugeben, bei der eine erhöhte Speicherdichte erzielt wird und die mit wenigen Herstellungsschritten und hoher Ausbeute herstellbar ist. Desweiteren soll ein Verfahren zur Herstellung einer solchen Speicherzellenanordnung angegeben werden.

Das Problem wird erfindungsgemaß gelöst durch eine Festwertspeicherzellenanordnung gemäß Anspruch 1 sowie ein Verfahren zu deren Herstellung gemäß Anspruch 3. Weitere Ausgestaltungen der Erfindung ergeben sich aus den Unteransprüchen.

In der erfindungsgemäßen Festwertspeicherzellenanordnung ist in einem Halbleitersubstrat, vorzugsweise aus monokristallinem Silizium oder in einer Siliziumschicht eines SOI-Substrates, ein Zellenfeld mit Speicherzellen vorgesehen. Dabei ist ein erster logischer Wert jeweils in ersten Speicherzellen, ein zweiter logischer Wert jeweils in zweiten Speicherzellen gespeichert. Die ersten Speicherzellen umfassen einen zur Hauptfläche des Halbleitersubstrates vertikalen MOS-Transistor. Die zweiten Speicherzellen umfassen dagegen keinen MOS-Transistor.

Die Programmierung der Festwertspeicherzellenanordnung erfolgt bei der Herstellung dadurch, daß an vorbestimmten Orten für erste Speicherzellen vertikale MOS-Transistoren realisiert werden, während vorbestimmte Stellen für zweite Speicherzellen maskiert sind, so daß hier keine MOS-Transistoren entstehen.

Im Zellenfeld sind mehrere, im wesentlichen parallel verlaufende, streifenförmige Isolationsgräben vorgesehen. Die Isolationsgräben verlaufen über das gesamte Zellenfeld. Die Speicherzellen sind jeweils an gegenüberliegenden Flanken der Isolationsgräben angeordnet. Dabei überlappt die Fläche der Speicherzellen die jeweilige Flanke.

Am Boden der Isolationsgräben und an der Hauptfläche des Halbleitersubstrats jeweils zwischen benachbarten Isolationsgräben sind streifenförmige, dotierte Gebiete angeordnet, die entgegengesetzt zum Halbleitersubstrat dotiert sind. Die streifenförmigen, dotierten Gebiete verlaufen parallel zu den Isolationsgräben über das gesamte Zellenfeld. Die vertikalen MOS-Transistoren der ersten Speicherzellen werden so realisiert, daß jeweils ein am Boden eines Isolationsgrabens verlaufendes streifenförmiges, dotiertes Gebiet und ein zwischen dem Isolationsgraben und dem benachbarten Isolationsgraben an der Hauptfläche angeordnetes streifenförmiges, dotiertes Gebiet die Source/Drain-Gebiete des MOS-Transistors bilden. Gatedielektrikum und Gatelektrode des MOS-Transistors sind in einem Loch angeordnet, das an die Flanke des Isolationsgrabens angrenzt und sich bis in den Isolationsgraben hinein erstreckt. Dieses Loch ist mit Gatedielektrikum und Gateelektrode ausgefüllt.

An der Hauptfläche sind Wortleitungen angeordnet, die quer zu den Isolationsgräben verlaufen. Die Wortleitungen sind jeweils mit Gateelektroden von unterhalb der jeweiligen Wortleitung angeordneten vertikalen MOS-Transistoren verbunden.

Die streifenförmigen, dotierten Gebiete, die am Boden der Isolationsgräben und jeweils zwischen benachbarten Isolationsgräben an der Hauptfläche des Halbleitersubstrats angeordnet sind, werden zum Auslesen der Speicherzellen als Bit-bzw. Referenzleitung verwendet. Die zu bewertende Speicherzelle wird über die Wortleitung ausgewählt. Es wird bewertet, ob zwischen den zugehörigen streifenförmigen dotierten Gebieten ein Strom fließt oder nicht. Ist die Speicherzelle eine erste Speicherzelle, so bilden die zugehörigen streifenförmigen, dotierten Gebiete die Source/Drain-Gebiete eines vertikalen MOS-Transistors, dessen Gateelektrode mit der Wortleitung verbunden ist, so daß in diesem Fall ein Strom fließt. Ist die Speicherzelle jedoch eine zweite Speicherzelle, so befindet sich an dieser Stelle kein Loch, kein Gatedielektrikum und keine Gateelektrode. Die Wortleitung verläuft lediglich an der Hauptfläche des Halbleitersubstrats über einen Isolator. Es kann daher kein Strom zwischen den zugehörigen streifenförmigen dotierten Gebieten fließen.

Vorzugsweise wird der Abstand zwischen benachbarten Isolationsgräben so gewählt, daß er im wesentlichen gleich der Breite der Isolationsgräben ist. In den ersten Speicherzellen erstreckt sich das Loch in diesem Fall vorzugsweise jeweils bis zur halben Breite des Isolationsgrabens. Die Speicherzellenfläche erstreckt sich senkrecht zum Verlauf der Isolationsgräben jeweils von der Mitte des Isolationsgrabens bis zur Mitte des Abstands zum benachbarten Isolationsgraben. Wird die Breite der Isolationsgräben entsprechend der minimalen Strukturbreite F in der jeweiligen Technologie gewählt und die Breite der Wortleitungen und Abstand der Wortleitungen ebenfalls entsprechend der minimalen Strukturbreite F in der jeweiligen Technologie gewählt, so ergibt sich für die Speicherzelle ein Platzbedarf von 2 F². Legt man eine minimale Strukturbreite von F = 0,4 µm zugrunde, so wird in der Festwertspeicherzelleanordnung eine Speicherdichte von etwa 3,1 Bit/µm² erzielt.

Zur Herstellung der erfindungsgemäßen Festwertspeicherzellenanordnung wird vorzugsweise zunächst an der Hauptfläche des Halbleitersubstrats im Bereich des Zellenfeldes ein dotiertes Gebiet erzeugt. Anschließend wird vorzugsweise eine Ätzstopschicht (Polysilizium oder Nitrid) aufgebracht. Dann werden unter Verwendung einer Grabenmaske Gräben geätzt, wobei die streifenförmigen, dotierten Gebiete zwischen benachbarten Isolationsgräben an die Hauptfläche durch Strukturierung des dotierten Gebietes entstehen. Durch Ionenimplantation werden die am Boden der Gräben angeordneten streifenförmigen dotierten Gebiete gebildet. Dabei ist die Hauptfläche zwischen benachbarten Gräben durch die Grabenmaske geschützt. Um eine zusätzliche Dotierung der Seitenwände der Gräben durch gestreute Ionen zu vermeiden, ist es vorteilhaft, vor der Ionenimplantation die Seitenwände der Gräben mit Spacern, zum Beispiel aus SiO₂, zu versehen.

Nach der Implantation zur Bildung der streifenförmigen, dotierten Gebiete am Boden der Gräben werden die Gräben mit isolierendem Material, zum Beispiel SiO₂, aufgefüllt.

Nach Auffüllen der Gräben erfolgt die Herstellung der Speicherzellen, wobei die Festwertspeicherzellenanordnung programmiert wird. Dazu wird eine Photolackmaske erzeugt, die die Hauptfläche des Halbleitersubstrats nur an den Stellen unbedeckt läßt, an denen ein Loch für eine erste Speicherzelle entstehen soll. In einem anisotropen Trockenätzprozeß werden die Löcher an der Flanke der Isolationsgräben geätzt. Dabei wird an der Flanke die Halbleiteroberfläche freigelegt. Das Loch erstreckt sich in den Isolationsgraben hinein. Parallel zum Isolationsgraben ist das Loch vorzugsweise entsprechend der Breite der Wortleitungen begrenzt. Das Loch reicht bis auf die Oberfläche des streifenförmigen dotierten Gebietes am Boden des Isolationsgrabens. Die Halbleiteroberfläche im Loch wird mit einem Gatedielektrikum versehen. Anschließend wird das Loch mit einer Gateelektrode aufgefüllt.

Es liegt im Rahmen der Erfindung, unter der Grabenmaske eine Ätzstopschicht vorzusehen, die vor der Grabenatzung entsprechend der Grabenmaske strukturiert wird. Die Ätzstopschicht wird aus einem solchen Material erzeugt, daß das isolierende Material der Isolationsgräben selektiv zur Ätzstopschicht ätzbar ist. Die strukturierte Ätzstopschicht wirkt bei der Lochätzung gemeinsam mit der Photolackmaske als Ätzmaske. Daher kann die Breite der Isolationsgräben entsprechend der minimalen Strukturbreite F eingestellt werden. Die Löcher in der Photolackmaske weisen ebenfalls lineare Abmessungen entsprechend der minimalen Strukturbreite F auf. Die Photolackmaske wird in Bezug auf die Isolationsgräben so justiert, daß die Mitte der Löcher jeweils um eine halbe Breite der Isolationsgräben bezüglich der Mitte der Isolationsgräben versetzt angeordnet wird. Dabei wird ausgenutzt, daß die Justiergenauigkeit größer als die minimale Strukturbreite F ist. In der 0,4 µm-Technologie beträgt die minimale Strukturgröße F = 0,4 µm, die Justierung erfolgt auf besser als F/3 = 0,13 µm genau.

Da die Ätzstopschicht und die Photolackmaske gemeinsam als Ätzmaske wirken, wird die Breite des geätzten Loches um den Überlapp von Ätzstopschicht und Photolackmaske reduziert. Auf diese Weise ist es möglich, in einer F-Technologie ein Loch von einem ½ F Breite zu ätzen.

Es liegt im Rahmen der Erfindung, bei der Herstellung der Isolationsgräben im Zellenfeld gleichzeitig Isolationsgräben in einer Peripherie der Speicherzellenanordnung, die eine Ansteuerschaltung für die Speicherzellenanordnung umfaßt, zu bilden. Dazu sind Photolackmasken erforderlich, die die Peripherie während den Dotierungsschritten zur Bildung der streifenförmigen dotierten Gebiete im Zellenfeld abdecken. Ferner muß die Atzstopschicht, falls vorhanden, in der Peripherie entfernt werden, ehe in der Peripherie MOS-Transistoren zur Ansteuerung der Speicherzellenanordnung gebildet werden.

Im folgenden wird die Erfindung anhand eines Ausführungsbeispiels und der Figuren näher erläutert.
- Figur 1: zeigt ein Substrat mit einem dotierten Gebiet im Zellenfeld.
- Figur 2: zeigt das Substrat mit einer Grabenmaske nach der Ätzung von Gräben.
- Figur 3: zeigt das Substrat nach Bildung von streifenförmigen, dotierten Gebieten am Boden der Gräben.
- Figur 4: zeigt das Substrat nach dem Auffüllen der Gräben mit isolierendem Material.
- Figur 5: zeigt das Substrat nach einer Lochätzung zur Bildung erster Speicherzellen.
- Figur 6: zeigt das Substrat nach Bildung eines Gateoxids und Erzeugung einer dotierten Polysiliziumschicht.
- Figur 7: zeigt das Substrat nach Strukturierung der dotierten Polysiliziumschicht in Wortleitungen und Gateelektroden für MOS-Transistoren in der Peripherie sowie nach Erzeugung von Source/Drain-Gebieten für die MOS-Transistoren der Peripherie.
- Figur 8: zeigt eine Aufsicht auf ein Zellenfeld einer erfindungsgemäßen Festwertspeicherzellenanordnung.

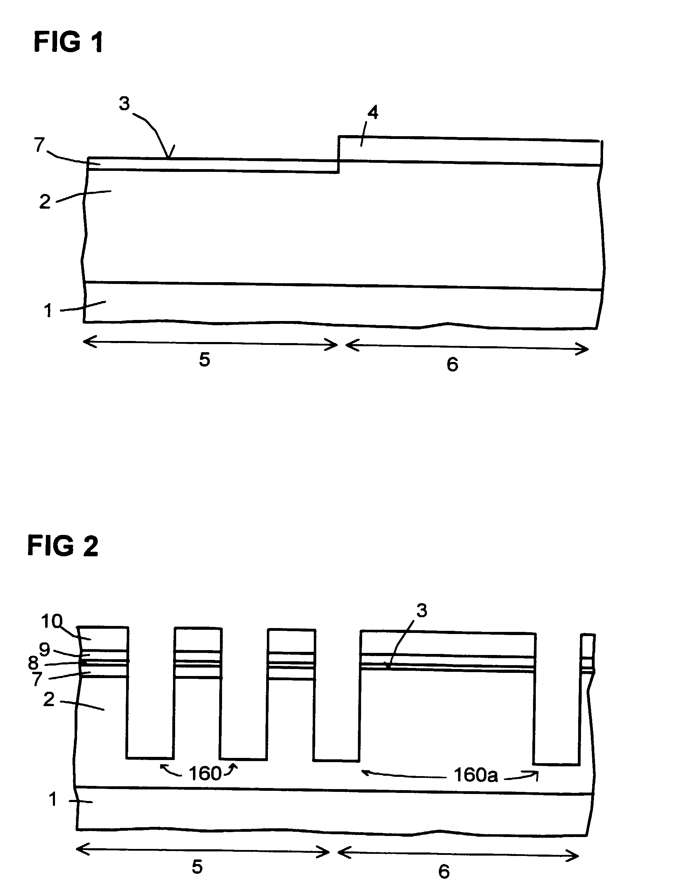

In einem Substrat 1 aus zum Beispiel p-dotiertem monokristallinem Silizium mit einer Dotierstoffkonzentration von 5 x 10¹⁵ cm⁻³ wird eine p-dotierte Wanne 2 mit einer Dotierstoffkonzentration von 2 x 10¹⁷ cm⁻³ durch Implantation und anschließendes Tempern erzeugt (siehe Figur 1). In einem CVD-TEOS Verfahren wird ein Streuoxid von 20 nm ganzflächig abgeschieden (nicht dargestellt). Anschließend wird auf einer Hauptfläche 3 des Substrats 1 eine Photolackmaske 4 erzeugt, die einen Bereich für ein Zellenfeld 5 und eine Peripherie 6 definiert. Die Photolackmaske 4 bedeckt den Bereich für die Peripherie 6 während die Hauptfläche 3 im Bereich für das Zellenfeld 5 freiliegt.

Durch Implantation mit 50 keV, 5 x 10¹⁵ cm⁻² wird ein n⁺-dotiertes Gebiet 7 erzeugt, das eine Dotierstoffkonzentration von 1 x 10²¹ cm⁻³ aufweist und das sich an der Hauptfläche 3 über den Bereich für das Zellenfeld 5 erstreckt.

Die Photolackmaske 4 wird entfernt und es folgt ein Temperschritt zum Aktivieren der Dotierstoffe. Das n⁺-dotierte Gebiet 7 weist eine Tiefe von etwa 200 nm auf. Die p-dotierte Wanne 2 weist eine Tiefe von 2 µm auf.

Das Streuoxid wird naßchemisch entfernt und es wird ganzflächig eine SiO₂-Schicht 8 in einer Dicke von zum Beispiel 60 nm durch thermische Oxidation erzeugt. Auf die SiO₂-Schicht 8 wird eine Ätzstopschicht 9 aufgebracht, die zum Beispiel aus Si3N4 oder Polysilizium in einem CVD-Verfahren abgeschieden wird. Die Ätzstopschicht 9 wird in einer Dicke von zum Beispiel 100 nm erzeugt.

Anschließend wird zur Bildung einer Grabenmaske 10 in einem TEOS-Verfahren eine 300 nm dicke SiO₂-Schicht abgeschieden und mit Hilfe photolithographischer Verfahren durch anisotropes Trockenätzen zum Beispiel mit CHF₃, O₂ strukturiert (siehe Figur 2).

Durch anisotropes Trockenätzen werden anschließend die Ätzstopschicht 9 und die SiO₂-Schicht 8 entsprechend der Grabenmaske 10 strukturiert. Das Ätzen der Ätzstopschicht 9 erfolgt mit CHF₃, O₂, falls diese aus Si₃N₄ besteht, und mit HBr, Cl₂ falls diese aus Polysilizium besteht. Die SiO₂-Schicht 8 wird mit CHF₃, O₂ geätzt. Nach Entfernen einer Photolackmaske, die zur Strukturierung der Grabenmaske 10 aufgebracht wurde, wird eine Grabenätzung durchgeführt. Die Grabenätzung erfolgt in einem anisotropen Trockenätzprozeß mit zum Beispiel HBr, He, O₂, NF₃. Dabei werden Gräben 160 erzeugt, die eine Tiefe von zum Beispiel 0,6 µm aufweisen. Die Gräben 160 erstrecken sich über einen Block des Zellenfeldes 5. Sie weisen eine Länge von zum Beispiel 250 µm und eine Breite von zum Beispiel 0,4 µm auf. Im Zellenfeld 5 sind benachbarte Gräben 160 in einem Abstand von 0,4 µm angeordnet. Die Gräben 160 verlaufen im wesentlichen parallel. Im Block des Zellenfeldes 5 werden zum Beispiel 64 parallele Gräben erzeugt.

Gleichzeitig werden in der Peripherie Gräben 160a, die für eine Shallow Trench-Isolation in Standardlogikprozessen benötigt werden, erzeugt. Die Gräben 160a in der Peripherie 6 weisen Abmessungen von zum Beispiel 0,4 µm Breite auf.

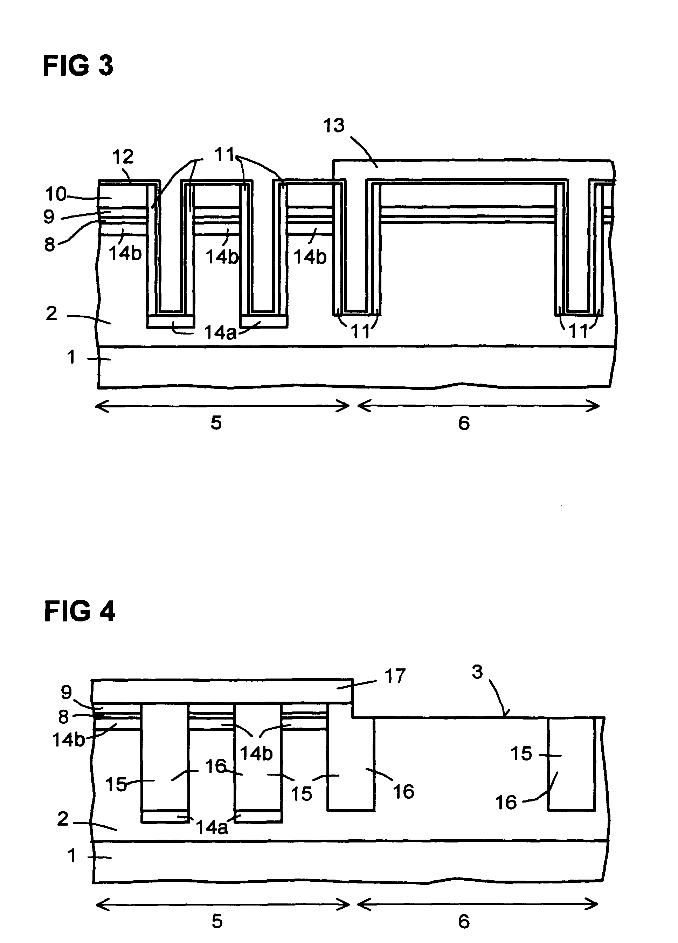

Durch konforme Abscheidung einer TEOS-SiO₂-Schicht in einer Dicke von 60 nm und anschließendes anisotropes Trockenätzen mit CHF₃, O₂ werden an senkrechten Flanken, insbesondere der Gräben 160 und der Grabenmaske 10 SiO₂-Spacer 11 erzeugt (siehe Figur 3).

Anschließend wird ganzflächig in einem TEOS-Verfahren eine Streuoxidschicht 12 in einer Dicke von 20 nm abgeschieden. Es wird eine Photolackmaske 13 erzeugt, die die Peripherie 6 abdeckt und das Zellenfeld 5 unbedeckt läßt. Es wird eine Ionenimplantation durchgeführt, bei der am Boden der Gräben 160 n⁺-dotierte, streifenförmige Gebiete 14a gebildet werden. Die Photolackmaske 13 wird gestrippt und die dotierten Gebiete werden durch einen Temperschritt aktiviert. In den streifenförmigen, dotierten Gebieten 14a wird eine Dotierstoffkonzentration von zum Beispiel 10²¹ cm⁻³ eingestellt. An der Hauptfläche 3 des Halbleitersubstrats 1 sind zwischen benachbarten Gräben 160 bei der Grabenätzung streifenförmige, dotierte Gebiete 14b durch Strukturierung des n⁺-dotierten Gebietes 7 entstanden.

Anschließend wird die Grabenmaske 10 entfernt. Die Entfernung der Grabenmaske 10 erfolgt zum Beispiel mit HF-Dampf (Excalibur-Anlage) oder in einem HF-Dip. Beim Entfernen der Grabenmaske 10 wird auch die Streuoxidschicht 12 und die SiO₂-Spacer 11 entfernt. Dabei werden in den Gräben 160 die Oberflächen der p-dotierten Wanne 2 freigelegt. Um die Qualität dieser Kristalloberflächen zu verbessern, wird durch thermische Oxidation eine SiO₂-Schicht in einer Dicke von 20 nm erzeugt. Diese SiO₂-Schicht ist in den Figuren der Übersichtlichkeit halber nicht dargestellt.

Anschließend werden die Gräben 160 durch Abscheidung einer TEOS-SiO₂-Schicht in einer Dicke von zum Beispiel 800 nm aufgefüllt. Durch Rückätzen mit CHF₃, O₂ werden die Anteile der TEOS-SiO₂-Schicht oberhalb der Hauptfläche 3 entfernt. Das Rückätzen stoppt auf der Ätzstopschicht 9. In diesem Prozeßschritt sind die Gräben 160 mit einer Grabenfüllung 15 aus SiO₂ versehen worden. Die Gräben 160 und die Grabenfüllung 15 bilden zusammen Isolationsgräben 16 (siehe Figur 4). In einem Temperschritt bei zum Beispiel 900°C während zum Beispiel 10 min wird die Grabenfüllung 15 verdichtet. Dadurch verändern sich die Ätzeigenschaften des SiO₂.

Es wird eine Photolackmaske 17 erzeugt, die das Zellenfeld 5 abdeckt. Unter Verwendung der Photolackmaske 17 als Ätzmaske wird die Ätzstopschicht 9 im Bereich der Peripherie 6 und im Bereich der Kontakte zu den Bitleitungen am Rand des Zellenfeldes entfernt. Anschließend wird eine Implantation mit zum Beispiel 8 x 10¹² cm⁻², Bor durchgeführt, über die die Schwellenspannung von später im Bereich der Peripherie herzustellenden MOS-Transistoren eingestellt wird. Schließlich wird die SiO₂-Schicht 8 im Bereich der Peripherie 6 entfernt. Die Photolackmaske 17 wird gestrippt.

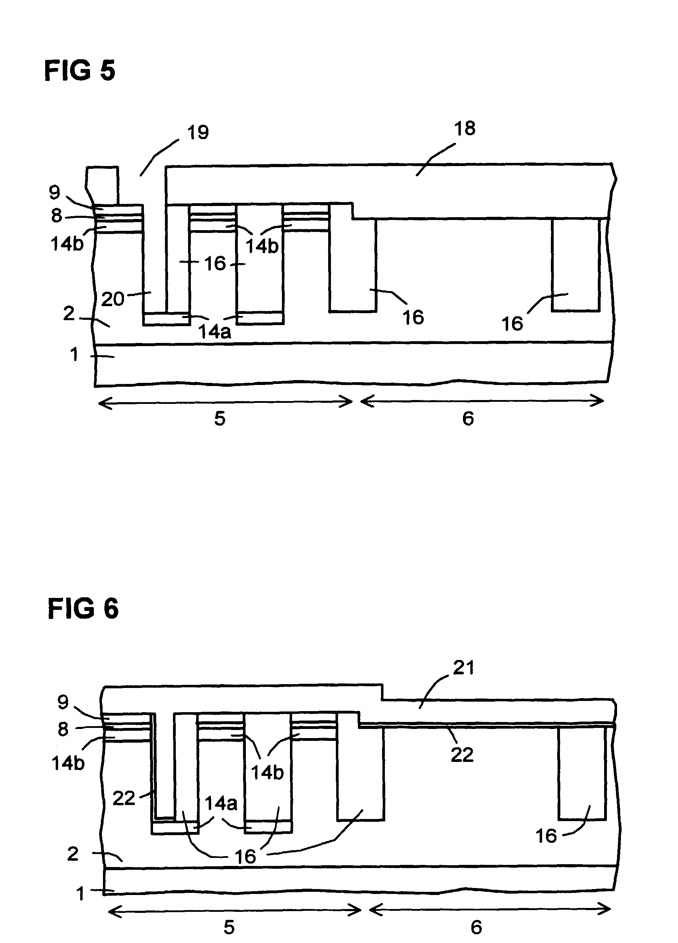

Es wird ganzflächig eine Photolackmaske 18 erzeugt (siehe Figur 5), die die Information, die in der Festwertspeicherzellenanordnung gespeichert werden soll, enthält. Die Photolackmaske 18 weist Öffnungen 19 auf an Orten, an denen im Zellenfeld 5 erste Speicherzellen gebildet werden sollen. Orte, an denen im Zellenfeld 5 zweite Speicherzellen gebildet werden sollen, sind dagegen von der Photolackmaske 18 bedeckt. Die Öffnungen 19 der Photolackmaske weisen einen im wesentlichen quadratischen Querschnitt parallel zur Hauptfläche 3 auf mit einer Seitenlänge von einer minimalen Strukturbreite zum Beispiel F = 0,4 µm. Die Photolackmaske 18 wird so justiert, daß die Mitten der Öffnungen 19 um eine halbe Strukturbreite F in Bezug auf die Mitte der Isolationsgräben 16 versetzt angeordnet ist. Dabei wird ausgenutzt, daß die Justierung genauer als die minimale Strukturbreite in einer Technologie ist. Die Peripherie 6 wird von der Photolackmaske 18 abgedeckt.

In einem anisotropen Trockenätzprozeß, der selektiv zur Ätzstopschicht 9 die Grabenfüllung 15 angreift, werden Löcher 20 in die Isolationsgräben 16 geätzt. Besteht die Ätzstopschicht aus Si₃N₄, so erfolgt die Ätzung mit C₂F₆, C₃F₈. Besteht die Ätzstopschicht 9 aus Polysilizium, so erfolgt die Ätzung mit HBr, Cl₂, He. Die Ätzung wird fortgesetzt, bis 700 nm SiO₂ entfernt sind. Die Löcher 20 reichen dann bis auf die Oberfläche des streifenförmigen, dotierten Gebietes 14a, das am Boden des jeweiligen Isolationsgrabens 16 angeordnet ist. Da die strukturierte Ätzstopschicht 9 und die Photolackmaske 18 gemeinsam als Ätzmaske wirken, ist die Breite des Lochs 20 senkrecht zum Verlauf der Isolationsgräben 16 geringer als die minimale Strukturbreite F in der jeweiligen Technologie. An einer Seitenwand und am Boden des Loches 20 ist die Halbleiteroberfläche freigelegt.

Anschließend wird die Photolackmaske 18 entfernt. In einem HF-Dip werden Ätzprodukte, die sich an den Wänden der Löcher 20 beim anisotropen Ätzen niedergeschlagen haben, entfernt. Zur Verbesserung der Halbleiteroberfläche wird anschließend ein thermisches sacrificial Oxid zum Beispiel von 10 nm erzeugt und anschließend naßchemisch entfernt.

Durch thermische Oxidation wird eine Gateoxidschicht 22 auf freiliegenden Halbleiteroberflächen in den Löchern 20 sowie in der Peripherie 6 erzeugt. Die Gateoxidschicht 22 wird in einer Dicke von zum Beispiel 10 nm erzeugt (siehe Figur 6). Anschließend wird eine dotierte Polysiliziumschicht 21 in einer Dicke von 400 nm erzeugt. Die dotierte Polysiliziumschicht 21 wird zum Beispiel undotiert abgeschieden und durch Implantation oder Diffusion, zum Beispiel nach POCl-Belegung, n-dotiert. Alternativ wird die dotierte Polysiliziumschicht 21 durch insitu-dotierte Abscheidung erzeugt. Die dotierte Polysiliziumschicht 21 füllt die Löcher 20 vollständig aus.

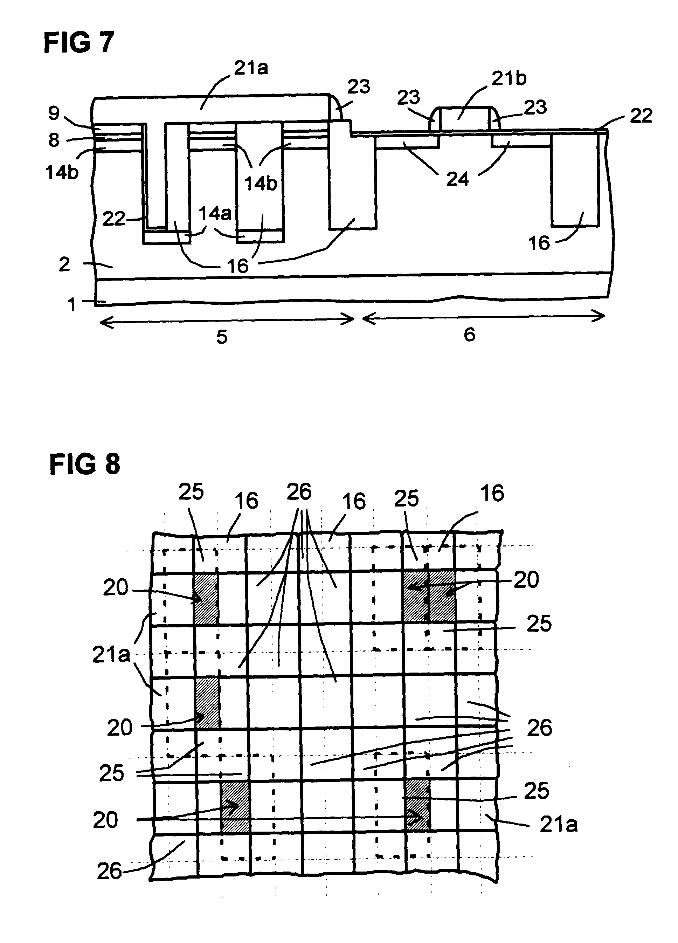

Mit Hilfe photolithographischer Verfahren wird die dotierte Polysiliziumschicht 21 so strukturiert, daß im Bereich des Zellenfeldes 5 Wortleitungen 21a und im Bereich der Peripherie 6 Gateelektroden 21b entstehen (siehe Figur 7). Der in den Löchern 20 angeordnete Teil der dotierten Polysiliziumschicht 21 wirkt als Gateelektrode für vertikale Transistoren, die aus den dotierten streifenförmigen Gebieten 14a, 14b, die an das jeweilige Loch 20 angrenzen, den dazwischen angeordneten Teil der p-dotierten Wanne 2 und der Gateoxidschicht 22 gebildet werden. Die Schwellenspannung dieser vertikalen MOS-Transistoren ist über die Dotierung der p-dotierten Wanne 2 vorgegeben.

Die Wortleitungen 21a verlaufen im wesentlichen senkrecht zu den Isolationsgräben 16. Sie weisen eine Breite von einer minimalen Strukturbreite F auf und sind im Abstand von zum Beispiel F = 0,4 µm angeordnet. Durch den Abstand benachbarter Wortleitungen 21a sind entlang einer Flanke eines Isolationsgrabens 16 benachbarte Speicherzellen gegeneinander isoliert. Im Bereich des Zellenfeldes 5 sind zum Beispiel 64 Wortleitungen 21a parallel nebeneinander angeordnet. Die Gateelektroden der vertikalen MOS-Transistoren sind herstellungsbedingt mit der jeweiligen Wortleitung 21a verbunden.

Zur Fertigstellung der Festwertspeicherzellenanordnung werden in der Peripherie 6 laterale MOS-Transistoren erzeugt. Dazu werden durch konforme Abscheidung und anisotrope Ätzung einer SiO₂-Schicht an senkrechten Flanken der Wortleitungen 21a sowie der Gateelektroden 21b SiO₂-Spacer 23 erzeugt. Durch Implantation mit zum Beispiel Arsen bei einer Energie von 50 keV und einer Dosis von 5 x 10¹⁵ cm⁻² werden in der Peripherie 6 Source/Drain-Gebiete 24 gebildet. Da die Source/Drain-Gebiete 24 der MOS-Transistoren in der Peripherie 6 vom gleichen Leitfähigkeitstyp dotiert sind wie die Gateelektrode 21b und die Wortleitungen 21a, kann diese Implantation ohne zusätzliche Maske erfolgen.

Zur Herstellung der lateralen MOS-Transistoren in der Peripherie 6 können weitere, aus der MOS-Technik bekannte Verfahrensschritte wie LDD-Profil, HDD-Profil, Salicide-Technik und ähnliches durchgeführt werden.

Unter Verwendung zusätzlicher Masken und Prozesse kann auch ein P-MOS-Transistor in der Perpherie hergestellt werden.

Schließlich wird ganzflächig eine planarisierende Zwischenoxidschicht zum Beispiel aus Bor-Phosphor-Silikat-Glas abgeschieden, in der Kontaktlöcher geöffnet werden. Kontaktlöcher werden unter anderem zu den Wortleitungen 21a, zu den streifenförmigen dotierten Gebieten 14a, die am Boden der Isolationsgräben 16 angeordnet sind und zu den streifenförmigen, dotierten Gebieten 14b, die an der Hauptfläche 3 zu den benachbarten Isolationsgräben 16 angeordnet sind, geöffnet. Die Kontaktlöcher werden zum Beispiel mit Wolfram aufgefüllt. Es folgt die Erzeugung einer Metallisierungsebene zum Beispiel durch Abscheidung und Strukturierung einer Aluminiumschicht. Schließlich wird eine Passivierungsschicht aufgebracht. Diese Standardschritte sind nicht im einzelnen dargestellt.

In der erfindungsgemäß hergestellten Festwertspeicherzellenanordnung erfolgt die Bewertung der Speicherzelle nach dem "virtual ground"-Prinzip. Jedes der streifenförmigen, dotierten Gebiete 14a, 14b ist zwei Reihen von Speicherzellen zugeordnet. Ein Paar der streifenförmigen, dotierten Gebiete 14a, 14b, das aus benachbart angeordneten dotierten Gebieten an der Hauptfläche 14a und am Boden 14b zusammengesetzt ist, ist dabei eindeutig einer Reihe Speicherzellen zugeordnet. Beim Auslesen der Festwertspeicherzellenanordnung wird daher nach Auswahl über die Wortleitung 21a der Stromfluß zwischen einem streifenförmigen dotierten Gebiet 14a am Boden eines Isolationsgrabens und einem benachbarten streifenförmigen dotierten Gebiet 14b an der Hauptfläche 3 bewertet. Die streifenförmigen, dotierten Gebiete 14a, 14b am Boden der Isolationsgräben und an der Hauptfläche 3 wirken je nach Beschaltung als Referenz- oder Bitleitung.

Figur 8 zeigt eine Aufsicht auf das Zellenfeld 5 der erfindungsgemäßen Festwertspeicherzellenanordnung. Die Festwertspeicherzellenanordnung umfaßt im Zellenfeld 5 erste Speicherzellen 25 sowie zweite Speicherzellen 26. Die Zellengröße der ersten Speicherzellen 25 und der zweiten Speicherzellen 26 sind in Figur 8 als strichpunktierte Linie eingetragen.Die ersten Speicherzellen 25 sind jeweils durch eine punktierte Linie hervorgehoben. In den ersten Speicherzellen 25 ist jeweils ein erster logischer Wert, in den zweiten Speicherzellen 26 ein zweiter logischer Wert gespeichert.

Der erste logische Wert wird in den ersten Speicherzellen 25 dadurch eingeschrieben, daß im Bereich der ersten Speicherzellen 25 durch Ätzung des Loches 20 und Bildung von Gateoxid 22 und Gateelektrode 21 ein vertikaler MOS-Transistor gebildet wird, dessen Gateelektrode mit einer der Wortleitungen 21a verbunden ist.

Der zweite logische Wert wird in den zweiten Speicherzellen 26 dadurch eingeschrieben, daß im Bereich der zweiten Speicherzellen 26 kein Loch geätzt wird und damit im weiteren Herstellungsverfahren kein vertikaler MOS-Transistor entsteht. Die über die zweiten Speicherzellen 26 verlaufenden Wortleitungen 21a sind damit im Bereich der zweiten Speicherzellen 26 nicht mit einer vertikalen Gateelektrode verbunden. Dadurch kann bei Auswahl einer zweiten Speicherzelle 26 über die entsprechenden streifenförmigen dotierten Gebiete 14a, 14b kein Strom fließen.

Die erfindungsgemäße Festwertspeicherzellenanordnung kann mit neun Masken hergestellt werden, wobei gleichzeitig mit dem Zellenfeld 5 laterale N-MOS Transistoren in der Peripherie 6 hergestellt werden. Der Flächenbedarf einer Speicherzelle 25, 26 beträgt in diesem Ausführungsbeispiel 2F², wobei F die in der jeweiligen Lithographie kleinste herstellbare Strukturgröße ist.

## Patentansprüche

1. Festwertspeicherzellenanordnung,
- bei der an einer Hauptfläche (3) eines Halbleitersubstrats (1) ein Zellenfeld (5) mit Speicherzellen (25, 26) vorgesehen ist,
- bei der das Halbleitersubstrat (1) mindestens im Bereich des Zellenfeldes (5) von einem ersten Leitfähigkeitstyp dotiert ist,
- bei der die Speicherzellen erste Speicherzellen (25), in denen ein erster logischer Wert gespeichert ist und die mindestens einen zur Hauptfläche (3) vertikalen MOS-Transistor aufweisen, und zweite Speicherzellen (26), in denen ein zweiter logischer Wert gespeichert ist und die keinen MOS-Transistor aufweisen, umfassen,
- bei der im Zellenfeld (5) mehrere, im wesentlichen parallel verlaufende streifenförmige Isolationsgräben (16) vorgesehen sind,
- bei der am Boden der Isolationsgräben (16) und an der Hauptfläche (3) zwischen benachbarten Isolationsgräben (16) jeweils streifenförmige, dotierte Gebiete (14a, 14b) angeordnet sind, die von einem zweiten, vom ersten entgegengesetzten Leitfähigkeitstyp dotiert sind und die im wesentlichen parallel zu den Isolationsgräben (16) verlaufen,
- bei der die Speicherzellen jeweils an gegenüberliegenden Flanken der Isolationsgräben (16) angeordnet sind,
- bei der die ersten Speicherzellen (25) jeweils ein Loch (20) umfassen, das sich von einer Flanke eines der Isolationsgräben (16) in den Isolationsgraben (16) hinein erstreckt, dessen Oberfläche mit einem Gatedielektrikum (22) versehen ist und das mit einer Gateelektrode (21) aufgefüllt ist, so daß die an die Flanke angrenzenden, streifenförmigen dotierten Gebiete (14a, 14b) die Source/Drain-Gebiete des vertikalen MOS-Transistors bilden,
- bei der Wortleitungen (21a) vorgesehen sind, die quer zu den Isolationsgräben (16) verlaufen und die jeweils mit Gateelektroden von vertikalen MOS-Transistoren verbunden sind, die unterhalb der jeweiligen Wortleitung (21a) angeordnet sind.

2. Festwertspeicherzellenanordnung nach Anspruch 1,
- bei der der Abstand zwischen benachbarten Isolationsgräben (16) im wesentlichen gleich der Breite der Isolationsgräben (16) ist,
- bei der sich in den ersten Speicherzellen (25) das Loch (20) jeweils bis zur halben Breite des Isolationsgrabens (16) erstreckt.

3. Verfahren zur Herstellung einer Festwertspeicherzellenanordnung nach Anspruch 1 oder 2,
- bei dem an einer Hauptfläche (3) eines Halbleitersubstrats (1) ein Zellenfeld (5) mit ersten Speicherzellen (25), in denen ein erster logischer Wert gespeichert ist und die mindestens einen zur Hauptfläche (3) vertikalen MOS-Transistor umfassen, und zweiten Speicherzellen (26), in denen ein zweiter logischer Wert gespeichert ist und die keinen MOS-Transistor umfassen, gebildet wird,
- bei dem das Halbleitersubstrat (1) mindestens im Bereich des Zellenfeldes (5) von einem ersten Leitfähigkeitstyp dotiert ist,
- bei dem mehrere im wesentlichen parallel verlaufende, streifenförmige Isolationsgräben (16) erzeugt werden,
- bei dem am Boden der Isolationsgräben (16) und an der Hauptfläche (3) zwischen benachbarten Isolationsgräben (16) jeweils streifenförmige, dotierte Gebiete (14a, 14b) gebildet werden, die von einem zweiten, zum ersten entgegengesetzten Leitfähigkeitstyp dotiert sind,
- bei dem die Speicherzellen jeweils an gegenüberliegenden Flanken der Isolationsgräben (16) gebildet werden, wobei entlang einer Flanke benachbarte Speicherzellen gegeneinander isoliert werden,
- bei dem zur Bildung vertikaler Transistoren Löcher (20) geöffnet werden, die jeweils an eine Flanke eines der Isolationsgraben (16) angrenzen und bis auf das am Boden des Isolationsgrabens (16) verlaufende dotierte Gebiet (14a) reichen und deren Oberfläche mit einem Gatedielektrikum (22) und einer Gateelektrode (21) versehen wird,
- bei dem Wortleitungen (21a), die quer zu den Isolationsgräben verlaufen und die jeweils mit Gateelektroden von vertikalen MOS-Transistoren verbunden sind, erzeugt werden.

4. Verfahren nach Anspruch 3,
- bei dem zur Bildung der Isolationsgräben (16) und der streifenförmigen dotierten Gebiete (14a, 14b) an der Hauptfläche des Halbleitersubstrats (1) ein vom zweiten Leitfähigkeitstyp dotiertes Gebiet (7) erzeugt wird, das sich über das gesamte Zellenfeld (5) erstreckt,
- bei dem eine Grabenmaske erzeugt wird, die die Anordnung der Isolationsgräben (16) definiert,
- bei dem in einem anisotropen Trockenätzprozeß unter Verwendung der Grabenmaske (10) als Ätzmaske Gräben (160) geätzt werden, wobei die an der Hauptfläche (3) zwischen benachbarten Isolationsgräben (16) angeordneten, streifenförmigen dotierten Gebiete (14b) durch Strukturierung des vom zweiten Leitfähigkeitstyp dotierten Gebietes (7) gebildet werden,
- bei dem die am Boden der Gräben angeordneten streifenförmigen dotierten Gebiete (14a) durch Ionenimplantation gebildet werden, wobei die Grabenmaske (10) als Implantationsmaske wirkt,
- bei dem nach Entfernen der Grabenmaske (10) die Isolationsgräben (16) durch Auffüllen der Gräben (160) mit isolierendem Material (15) fertiggestellt werden.

5. Verfahren nach Anspruch 4,
- bei dem vor der Ionenimplantation zur Bildung der am Boden der Gräben angeordneten streifenförmigen dotierten Gebiete (14a) die Seitenwände der Gräben mit maskierenden Spacern (11) bedeckt werden, die vor dem Auffüllen der Gräben entfernt werden.

6. Verfahren nach Anspruch 4 oder 5,
- bei dem unter der Grabenmaske (10) eine Ätzstopschicht (9) erzeugt wird, zu der das isolierende Material der Isolationsgräben (16) selektiv ätzbar ist,
- bei dem die Ätzstopschicht vor der Grabenätzung entsprechend der Grabenmaske (10) strukturiert wird,
- bei dem nach Fertigstellung der Isolationsgräben (16) eine Photolackmaske (18) erzeugt wird, die die Anordnung der ersten Speicherzellen (25) definiert,
- bei dem in einem anisotropen Trockenätzprozeß, bei dem die Photolackmaske (18) und die strukturierte Ätzstopschicht (9) gemeinsam als Ätzmaske wirken, die Löcher (20) für die vertikalen MOS-Transistoren geöffnet werden.

7. Verfahren nach Anspruch 6,
- bei dem die Isolationsgräben (16) mit SiO₂ gefüllt werden,
- bei dem die Ätzstopschicht (9) mindestens eines der Materialien Si₃N₄, amorphes Silizium und Polysilizium enthält,
- bei dem das Halbleitersubstrat (1) mindestens im Bereich des Zellenfeldes (5) monokristallines Silizium umfaßt.

8. Verfahren nach einem der Ansprüche 4 bis 7,
- bei dem die laterale Ausdehnung des vom zweiten Leitfähigkeitstyp dotierten Gebietes (7) durch eine Photolackmaske (4) definiert wird, die gleichzeitig ein Gebiet für die Peripherie (6) abdeckt,
- bei dem mit der Grabenmaske (10) auch Gräben (160a) in der Peripherie (6) geätzt werden,
- bei dem die Peripherie (6) bei der Ionenimplantation zur Bildung der streifenförmigen dotierten Gebiete (14a) am Boden der Gräben (160) maskiert wird,
- bei dem die Gräben (160a) in der Peripherie (6) mit isolierendem Material (15) aufgefüllt werden.

## Claims

1. Read-only memory cell arrangement,
- in which a cell array (5) having memory cells (25, 26) is provided on one main surface (3) of a semiconductor substrate (1),
- in which the semiconductor substrate (1) is doped with a first conductivity type at least in the region of the cell array (5),
- in which the memory cells include first memory cells (25), in which a first logic value is stored and which have at least one MOS transistor which is vertical to the main surface (3), and second memory cells (26), in which a second logic value is stored and which have no MOS transistor,
- in which a plurality of essentially parallel strip-shaped insulation trenches (16) are provided in the cell array (5),
- in which strip-shaped doped regions (14a, 14b) are respectively arranged at the bottom of the insulation trenches (16) and on the main surface (3) between neighbouring insulation trenches (16), these regions being doped with a second conductivity type which is the opposite of the first, and extending essentially parallel to the insulation trenches (16),
- in which the memory cells are each arranged on opposite flanks of the insulation trenches (16),
- in which the first memory cells (25) each contain a hole (20) which extends from one flank of one of the insulation trenches (16) into the insulation trench (16), has its surface provided with a gate dielectric (22) and is filled with a gate electrode (21), so that the strip-shaped doped regions (14a, 14b) abutting against the flank form the source/drain regions of the vertical MOS transistor,
- in which word lines (21a) are provided, which extend transversely to the insulation trenches (16) and which are each connected to gate electrodes of vertical MOS transistors arranged below the respective word line (21a).

2. Read-only memory cell arrangement according to Claim 1,
- in which the separation between neighbouring insulation trenches (16) is essentially equal to the width of the insulation trenches (16),
- in which each of the holes (20) extends in the first memory cells (25) to half the width of the insulation trench (16).

3. Method for the production of a read-only memory cell arrangement according to Claim 1 or 2,
- in which a cell array (5), having first memory cells (25) in which a first logic value is stored and which have at least one MOS transistor vertical to the main surface (3), and second memory cells (26) in which a second logic value is stored and which do not have MOS transistors, is formed on a main surface (3) of a semiconductor substrate (1),
- in which the semiconductor substrate (1) is doped with a first conductivity type at least in the region of the cell array (5),
- in which a plurality of essentially parallel strip-shaped insulation trenches (16) are produced,
- in which strip-shaped doped regions (14a, 14b) are respectively formed at the bottom of the insulation trenches (16) and on the main surface (3) between neighbouring insulation trenches (16), these regions being doped with a second conductivity type which is the opposite of the first,
- in which the memory cells are each formed on opposite flanks of the insulation trenches (16), neighbouring memory cells along a flank being insulated from each other,
- in which, in order to form vertical transistors, holes (20) are opened which each abut against a flank of one of the insulation trenches (16) and extend as far as the doped region (14a) extending at the bottom of the insulation trench (16), the surface of these holes being provided with a gate dielectric (22) and a gate electrode (21),
- in which word lines (21a) which run transversely to the insulation trenches and are in each case connected to gate electrodes of vertical MOS transistors, are produced.

4. Method according to Claim 3,
- in which, in order to form the insulation trenches (16) and the strip-shaped doped regions (14a, 14b), a region (7) which is doped with the second conductivity type and extends over the entire cell array (5) is produced on the main surface of the semiconductor substrate (1),
- in which a trench mask which defines the arrangement of the insulation trenches (16) is produced,
- in which trenches (160) are etched in an anisotropic dry etching process, with the trench mask (10) being used as an etching mask, the strip-shaped doped regions (14b) arranged on the main surface (3) between neighbouring insulation trenches (16) being formed by structuring the region (7) doped with the second conductivity type,
- in which the strip-shaped doped regions (14a) arranged at the bottom of the trenches are formed by ion implantation, the trench mask (10) acting as an implantation mask,
- in which, after the trench mask (10) has been removed, the insulation trenches (16) are fabricated by filling the trenches (160) with insulating material (15).

5. Method according to Claim 4,
- in which, before the ion implantation for forming the strip-shaped doped regions (14a) arranged at the bottom of the trenches, the side walls of the trenches are covered with masking spacers (11) which are removed before the trenches are filled.

6. Method according to Claim 4 or 5,
- in which an etching barrier layer (9), with respect to which the insulating material of the insulation trenches (16) is selectively etchable, is produced under the trench mask (10),
- in which the etching barrier layer is structured in accordance with the trench mask (10) before the trenches are etched,
- in which, after the insulation trenches (16) have been fabricated, a photoresist mask (18) which defines the arrangement of the first memory cells (25) is produced,
- in which the holes (20) for the vertical MOS transistors are opened in an anisotropic dry etching process in which the photoresist mask (18) and the structured etching barrier layer (9) together act as an etching mask.

7. Method according to Claim 6,
- in which the insulation trenches (16) are filled with SiO₂,
- in which the etching barrier layer (9) contains at least one of the materials Si₃N₄, amorphous silicon and polysilicon,
- in which the semiconductor substrate (1) contains monocrystalline silicon at least in the region of the cell array (5).

8. Method according to one of Claims 4 to 7,
- in which the lateral extent of the region (7) doped with the second conductivity type is defined by a photoresist mask (4) which simultaneously covers a region for the periphery (6),
- in which trenches (160a) at the periphery (6) are also etched using the trench mask (10),
- in which the periphery (6) is masked during the ion implantation for forming the strip-shaped doped regions (14a) at the bottom of the trenches (160),
- in which the trenches (160a) at the periphery (6) are filled with insulating material (15).

## Revendications

1. Mémoire morte,
- dans laquelle une surface principale (3) d'un substrat semiconducteur (1) comporte un champ de cellules (5) contenant des cellules de mémoire (25, 26),
- dans laquelle le substrat semiconducteur (1) est dopé au moins dans la partie du champ de cellules (5) d'un premier type de conductivité,
- dans laquelle les cellules de mémoire présentent des premières cellules de mémoire (25), dans lesquelles est stockée une première valeur logique et qui comportent au moins un transistor MOS vertical par rapport à la surface principale (3), et des deuxièmes cellules de mémoire (26), dans lesquelles est stockée une deuxième valeur logique et qui ne comportent pas de transistor MOS,
- dans laquelle plusieurs tranchées d'isolation (16) en forme de bande sont prévues dans le champ de cellules (5), qui s'étendent essentiellement parallèlement,
- dans laquelle à chaque fois des zones dopées (14a, 14b) en forme de bande sont disposées au fond des tranchées d'isolation (16) et à la surface principale (3) entre tranchées d'isolation (16) voisines, qui sont d'un deuxième type de conductivité opposé au premier et qui s'étendent essentiellement parallèlement aux tranchées d'isolation (16),
- dans laquelle les cellules de mémoire sont à chaque fois disposées sur des flancs opposés des tranchées d'isolation (16),
- dans laquelle les premières cellules de mémoire (25) comportent chacune un trou (20) qui s'étend depuis un flanc d'une des tranchées d'isolation (16) dans la tranchée d'isolation (16), dont la surface est pourvue d'un diélectrique de grille (22) et qui est rempli d'une électrode de grille (21), de sorte que les zones dopées (14a, 14b) en forme de bande contiguës au flanc forment les zones source-drain du transistor MOS vertical,
- dans laquelle des lignes de mot (21a) sont prévues, qui s'étendent perpendiculairement aux tranchées d'isolation (16) et qui sont connectées à chaque fois à des électrodes de grille de transistors MOS verticaux disposés au-dessous de la ligne de mot (21a) respective.

2. Mémoire morte selon la revendication 1,
- dans laquelle la distance entre tranchées d'isolation (16) voisines est essentiellement égale à la largeur des tranchées d'isolation (16),
- dans laquelle le trou (20) dans les premières cellules de mémoire (25) s'étend à chaque fois jusqu'à la moitié de la largeur de la tranchée d'isolation (16).

3. Procédé de production d'une mémoire morte selon la revendication 1 ou 2,
- dans lequel on forme sur une surface principale (3) d'un substrat semiconducteur (1), un champ de cellules (5) comprenant des premières cellules de mémoire (25) dans lesquelles est stockée une première valeur logique et qui comportent au moins un transistor MOS vertical par rapport à la surface principale (3), et des deuxièmes cellules de mémoire (26) dans lesquelles est stockée une deuxième valeur logique et qui ne comportent pas de transistor MOS,
- dans lequel le substrat semiconducteur (1) est dopé au moins dans la partie du champ de cellules (5) d'un premier type de conductivité,
- dans lequel on crée plusieurs tranchées d'isolation (16) en forme de bande, qui s'étendent essentiellement parallèlement,
- dans lequel on forme au fond des tranchées d'isolation (16) et à la surface principale (3) entre tranchées d'isolation (16) voisines, à chaque fois des zones dopées (14a, 14b) en forme de bande d'un deuxième type de conductivité opposé au premier,
- dans lequel on forme les cellules de mémoire à chaque fois aux flancs opposés des tranchées d'isolation (16), les cellules de mémoire voisines le long d'un flanc étant isolées l'une de l'autre,
- dans lequel, pour former des transistors verticaux, on ouvre des trous (20) qui aboutissent à chaque fois à un flanc d'une des tranchées d'isolation (16) et s'avancent jusqu'à la zone dopée (14a) s'étendant au fond de la tranchée d'isolation (16) et dont la surface est pourvue d'un diélectrique de grille (22) et d'une électrode de grille (21),
- dans lequel on crée des lignes de mot (21a) qui s'étendent perpendiculairement aux tranchées d'isolation et qui sont à chaque fois connectées à des électrodes de grille de transistors MOS verticaux.

4. Procédé selon la revendication 3,
- dans lequel, pour former les tranchées d'isolation (16) et les zones dopées (14a, 14b) en forme de bande à la surface principale du substrat semiconducteur (1), on crée une zone dopée (7) du deuxième type de conductivité, qui s'étend sur tout le champ de cellules (5),
- dans lequel on crée un masque de tranchée qui définit la disposition des tranchées d'isolation (16),
- dans lequel, en utilisant le masque de tranchée (10) comme masque d'attaque, on réalise des tranchées (160) par un processus d'attaque chimique par voie sèche anisotrope, les zones dopées (14b) en forme de bande disposées à la surface principale (3) entre tranchées d'isolation (16) voisines étant formées par structuration de la zone dopée (7) du deuxième type de conductivité,
- dans lequel on forme les zones dopées (14a) en forme de bande disposées au fond des tranchées par implantation d'ions, le masque de tranchée (10) agissant comme masque d'implantation,
- dans lequel, après suppression du masque de tranchée (10), on achève les tranchées d'isolation (16) en remplissant les tranchées (160) d'un matériau isolant (15).

5. Procédé selon la revendication 4,
- dans lequel, avant l'implantation des ions pour former les zones dopées (14a) en forme de bande disposées au fond des tranchées, on couvre les parois latérales des tranchées d'écarteurs (11) masquants que l'on supprime avant de remplir les tranchées.

6. Procédé selon la revendication 4 ou 5,
- dans lequel on crée sous le masque de tranchée (10) une couche barrière (9) contre l'attaque chimique, par rapport à laquelle une attaque chimique sélective du matériau isolant des tranchées d'isolation (16) est possible,
- dans lequel, avant la réalisation des tranchées par attaque chimique, on structure la couche barrière selon le masque de tranchée (10),
- dans lequel, après réalisation des tranchées d'isolation (16), on crée un masque en laque photosensible (18) qui définit la disposition des premières cellules de mémoire (25),
- dans lequel on ouvre les trous (20) destinés aux transistors MOS verticaux, par un processus d'attaque chimique par voie sèche anisotrope où le masque en laque photosensible (18) et la couche barrière (9) contre l'attaque chimique agissent ensemble comme masque d'attaque.

7. Procédé selon la revendication 6,
- dans lequel on remplit les tranchées d'isolation (16) de SiO₂,
- dans lequel la couche barrière (9) contient au moins l'une des matières Si₃N₄, silicium amorphe et polysilicium,
- dans lequel le substrat semiconducteur (1) contient au moins dans la partie du champ de cellules (5) du silicium monocristallin.

8. Procédé selon l'une des revendications 4 à 7,
- dans lequel l'extension latérale de la zone dopée (7) du deuxième type de conductivité est définie par un masque en laque photosensible (4) qui couvre en même temps une zone de la périphérie (6),
- dans lequel on réalise par attaque chimique, à l'aide du masque de tranchées (10), également des tranchées (160a) à la périphérie (6),
- dans lequel on masque la périphérie (6) lors de l'implantation des ions pour former les zones dopées (14a) en forme de bande au fond des tranchées (160),
- dans lequel on remplit les tranchées (160a) à la périphérie (6) d'un matériau isolant (15).
